Europäisches Patentamt

European Patent Office

Office européen des brevets

(11) Publication number: **0 225 566**
**A2**

# (12) EUROPEAN PATENT APPLICATION

(21) Application number: **86116605.6**

(22) Date of filing: **28.11.86**

(51) Int. Cl.⁴: **H 01 L 29/80**

(30) Priority: **03.12.85 US 804636**

(43) Date of publication of application: **16.06.87 Bulletin 87/25**

(84) Designated Contracting States: **DE FR GB IT NL**

(71) Applicant: **ITT INDUSTRIES INC., 320 Park Avenue, New York, NY 10022 (US)**

(72) Inventor: **Griffin, Edward Lawrence, 6208 Saddleridge Lane, Roanoke, Va. 24018 (US)**

(74) Representative: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

(54) **Permeable gate transistor.**

(57) A field effect transistor comprises a semiconductor body having two major surfaces and including a substrate and an active region of one conductivity type forming a channel at one of the major surfaces. Elongated source and drain formations extend substantially parallel to a predetermined direction at the one major surface in juxtaposition with the active region and spaced from one another transversely to the predetermined direction. An elongated permeable gate formation is disposed at the one major surface between the source and drain formations in substantial parallelism with the predetermined direction and includes a plurality of gate portions situated at the semiconductor body and spaced from one another in the predetermined direction by predetermined distances to form intervening spaces, and a plurality of connecting portions integral with and interconnecting respective adjacent ones of the gate portions remotely from the body for supplying electric current to the gate portions for depleting respective individual depletion zones of the active region between the adjacent gate portions for controlling the flow of electric current in the channel between the source and drain formations.

## PERMEABLE GATE TRANSISTOR

### Background of the Invention

The present invention relates generally to field effect transistors (FETs), and more particularly to metal-semiconductor field effect transistors (MESFETs).

Basic principles of construction and operation of field-effect transistors are already known to those active in the field of designing semiconductor devices. Such transistors have found a widespread use in the electronics industry. However, experience has shown that severe constraints are placed on the use of such transistors at high frequencies. Yet, because of the relative simplicity and ease of manufacture, as well as reliability and durability of such transistors, it is desirable to be able to use them even at very high frequencies, for instance, in the Gigahertz range.

Various attempts have already been made at extending the range of frequencies in the upward direction, and some of these attempts have achieved a modicum of success. One of the main reasons for the existence of the upper limit on the operating frequency range for such transistors is that the electric field emanating from a gate of a transistor of this kind during the operation of the transistor to deplete a depletion zone of an active layer underneath and adjacent to the gate causes accumulation of charges of opposite polarities at the interface between the metallic material of the gate and the underlying layer, on the one hand, and at the boundary between the depletion zone and the remainder of the active layer, on the other hand, so that the gate exhibits a capacitance.

The maximum operating frequency $f_t$ can be determined from the equation

$$f_t = \frac{g_m}{2 \pi C}$$

wherein $g_m$ is the transconductance and C is the capacitance. Thus, it may be seen that, for the same $g_m$, the operating frequency is in an inverse proportion to the capacitance C.

This relationship has already been recognized and it was attempted to reduce the transistor capacitance by making the length of the gate (i.e. the dimension extending between the source and the drain) as small as Possible, such as in the submicron range. However, there are practical and especially manufacturing limits to further reductions in the gate length, and these limits are reflected in the above-mentioned upper limit on the operating frequency range.

### Summary of the Invention

Accordingly, it is a general object of the present invention to avoid the disadvantages of the prior art.

More particularly, it is an object of the present invention to provide a field-effect transistor, especially but not exclusively at MESFET, which does not possess the disadvantages of the known transistors of this type.

Still another object of the present invention is to construct the transistor of the type here under consideration in such a manner as to by reduce its capacitance below that of the known transistor constructions.

It is yet another object of the present invention to design the transistor of the above type in such a manner as to increase the upper limit of its operating frequency range.

A concomitant object of the present invention is to develop a transitor of the above-mentioned kind which is relatively simple in construction, inexpensive to manufacture, and reliable in operation even at very high operating frequencies nevertheless.

In pursuance of these objects and others which will become apparent hereafter, one feature of the present invention resides in a field effect transistor which comprises a semiconductor body having two major surfaces and including a substrate and an active region of one conductivity type forming a channel at one of the major surfaces; elongated source and drain formations extending substantially parallel to a predetermined direction at the one major surface in juxtaposition with the active region and spaced from one another transversely to the predetermined direction; and an elongated permeable gate formation disposed at the one major surface between the source and drain formations in substantial parallelism with the predetermined direction and including a plurality of gate portions situated at the semiconductor body and spaced from one another in the predetermined direction by predetermined distances to form intervening spaces, and a plurality of connecting portions integral with and interconnecting respective adjacent ones of the gate portions remotely from the body for supplying electric current to the gate portions for depleting respective individual depletion zones of the active region at least between the adjacent gate portions for controlling the flow of electic current in the channel between the source and drain formations.

A particular advantage of this arrangement is that, since the depletion zones which control the flow of the electric current through the channel between the source and drain formations are spaced from one another in the predetermined direction, such depletion zones are free to expand at the expense of the otherwise conductive zones underlying the spaces between the gate portions of the permeanble gate formation to partially if not completely block the flow of electric current through the channel underneath the aforementioned spaces, depending on the strength of the electric field generated by the gate portions. This mechanism, that is, the lateral expansion of the depletion zones, is the main if not exclusive mechanism for controlling the flow of the electric current in the channel of the active region; thus, the active region can be very thin, if not absent from, underneath the respective gate portions, so that the depletion underneath the gate portions, if at all necessary, takes place at very low electric field strengths. When the active layer is absent from underneath the gate portions, or so thin as to be depleted almost immediately at such locations, the gate capacitance is drastically reduced. In this manner, the operating frequency limit is significantly raised.

## Brief Description of the Drawing

Above-mentioned and other features and objects of this invention will become more apparent by reference to the following description taken in conjuction with the accompanying drawings, in which:

Fig. 1 is a top plan view of a transistor arrangement according to the present invention;

Fig. 2 is a sectional view through a gate formation of the transistor arrangement of Fig. 1, taken on line II - II;

Fig. 3 is an enlarged sectional view of a detail A of Fig. 2;

Fig. 4 is a sectional view taken on line IV - IV of Fig. 2; and

Fig. 5 is a view similar to that of Fig. 4 but showing a modified configuation of the gate formation.

## Detailed Description of the Preferred Embodiments

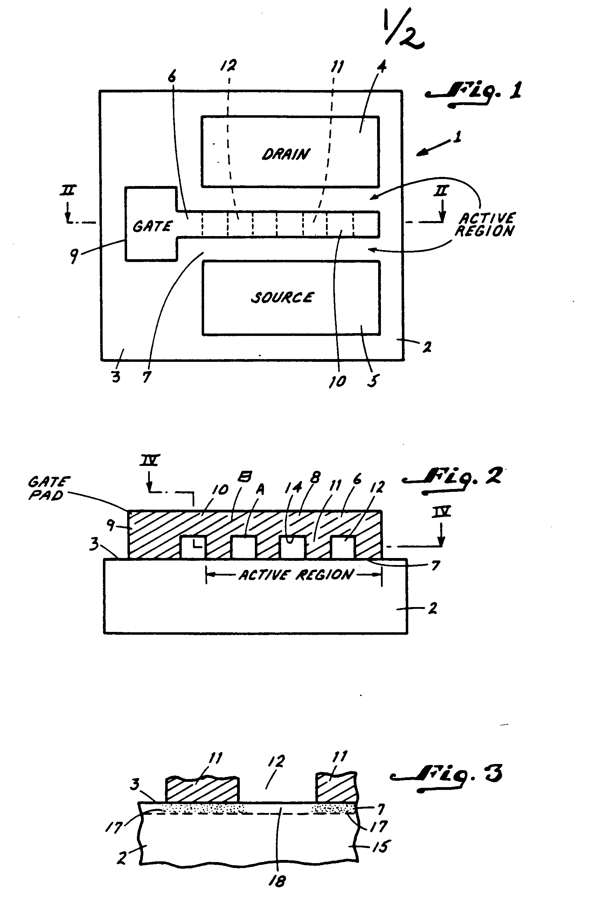

Referring now to the drawing in detail, and first to Fig. 1 thereof, it may be seen that the reference numeral 1 has been used therein to identify a transistor arrangement of the present invention in its entirety. The transistor arrangement 1, which may be constructed, for instance, in a manner resembling the known MESFET construction that will not be discussed here in any detail, includes a generally plate-shaped semiconductor body 2 having a major surface 3, respective drain and source formations 4 and 5 at the major surface 3, and a gate formation 6 situated between the drain and source formations 4 and 5. As usual, the drain and source formations 4 and 5 may include respective drain and source electrodes which are not separately shown and through which electric current to be controlled is distributed over the area of the drain and source formations 4 and 5. An active region 7 of the semiconductor body 2 is provided at the major surface 3 between the drain and source formations 4 and 5.

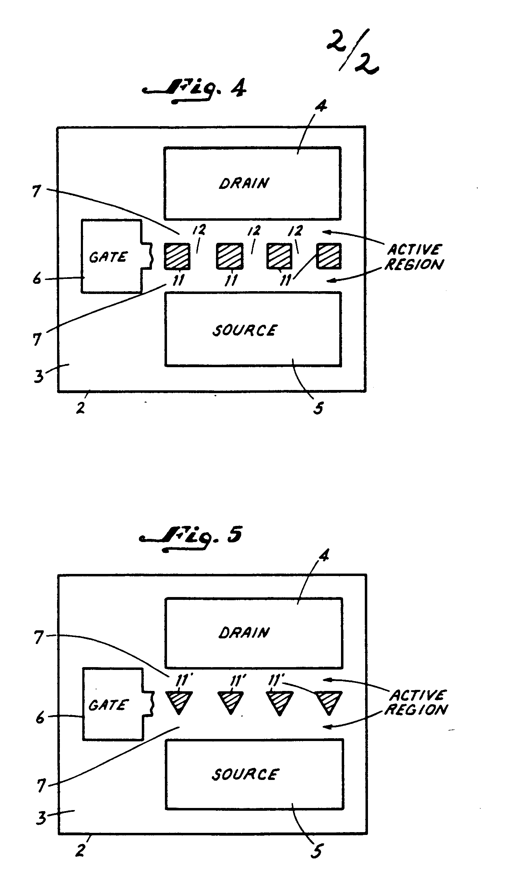

As a comparison of Figs. 1 and 2 will reveal, the gate formation 6 includes a gate electrode 8 which is provided on the major surface 3 of the semiconductor body 2 and includes an enlarged gate pad part 9 situated outside the active region 7 and a control part 10 which extends from the gate pad part 9 into juxtaposition with the active region 7. However, unlike in the conventional MESFET and similar transistor constructions where the control part 10 is in contact with the major surface 3 over its entire width (i.e. the dimension parallel to the larger dimensions of the drain and source formations 4 and 5), according to the present invention, only spaced posts or gate portions 11 of the control part 10 are in contact with the major surface 3 of the semiconductor body 2 at the active region 7, these gate portions 11 being separated from one another by intervening spaces 12 and being electrically connected with one another and with the gate pad part 9 by means of connecting portions 13 which are spaced from the major surface 3 and have inward surfaces 14 which face the major surface 3 but are spaced a predetermined distance therefrom. The intervening spaces 12 may be maintained with air bridging, or may be filled with a body of solid dielectric material.

- 5 -

Further details of the transistor arrangement 1 of the present invention can be ascertained from Fig. 3 of the drawing, in which certain relative dimensions have been purposely exaggerated with respect to the actual ones to be able to visualize the operation of the transistor arrangement 1. So, for instance, it may be seen that the semiconductor body 2 includes a substrate 15 on which the active region 7 is provided. The substrate 15 is, as usual, of a semi-insulating material such as, for instance, indium phosphate, and the active region may be provided as a discrete lattice-matched layer of, for instance, gallium arsenide or a ternary or quaternary compound of indium, gallium, phosphorus and indium. A multitude of such materials is known and in current use in the field of manufacturing semiconductor devices, such as MESFETS, so that such materials need not be particularly disclosed herein. However, the active region 7 may be formed in any other manner known to those active in the field of making semiconductor devices, such as by ion implantation, diffusion or the like which would not necessarily result in the formation of the active region 7 as a discrete layer, so that the boundary between the active region 7 and the substrate 15 is shown in broken lines. Regardless of the manner in which the active region is formed, what is important is that the material of the active region 7 be of one conductivity type, so as to permit the flow of electric charge carriers between the source and drain formations 5 and 4 through a channel formed in the active region 7.

When an electric charge is applied to the gate electrode 8 and thus to the gate portions 11, the electric field generated by such electric charge will emanate from the gate portions 11 into the active region 7, so that separate depletion zones 17 indicated by stippling will be formed underneath and adjacent to the respective gate portions 11, these depletion zones 17 being separated from one another by still conductive zones 18 of the active region 18 which are disposed underneath the intervening spaces 12. As illustrated in Fig. 3, the active region 7 has a constant thickness throughout. However, in contradistinction to known MESFET constructions, where the active region thickness has to be relatively large to permit substantially unimpeded flow of electric current in the channel at a low or non-existent gate charge and gradual reduction of the electric current flow as the gate charge increases, without premature pinching-off of the electric current flow, in the construction of the present invention the active region thickness underneath the gate portions 11 can be very small for early complete depletion, or the active region 7 can even be absent from underneath the gate portions 11, since the area underneath the gate portions 11 is not intended to contribute to any meaningful extent to the electric conductivity of the channel formed in the active region 7. Rather, the electric current conduction in the active region 7 takes place through the conductive zones 18 the cross-sectional area of which diminishes as the electric charge applied to the gate portions 11 increases with attendant spreading of the depletion regions 17 at the expense of the conduction zones 18 into the areas underlying the spaces 12. Now, since the capacitance of the gate formation 6 is proportionate to the distance of the depletion zone boundary from the gate/active layer interface until the depletion zone boudary reaches the active layer/substrate boundary and drastically drops thereafter, the non-existence or early depleteability of the active region 7 below the gate portions 11 drastically reduces the capacitance of the gate 6. On the other hand, the spreading or expansion of the depletion zones 17 at the expense of the conductive zones 18 as the charge applied to the gate portions 11 increases provides for reliable control of the flow of electric current in the channel of the active region 7 between the source and drain formations 5 and 4, but the attendant capacitance is only a small fraction of that encountered in the known FET constructions. Of course, the thickness of the active region 7 outside the areas juxtaposed with the gate portions 11 can exceed that within these areas, if so desired, for instance, to obtain the desired amount of electric current flow in the active layer 7 at low gate charges. So, for instance, the gate portions 11 could extend into respective recesses in the active region 7 of the semiconductor body 2.

As a result of the above-described construction of the transistor arrangement 1 and particularly of the gate formation 6 thereof, the gate capacitance may be reduced by a factor of two or even more as compared to a standard MESFET construction. The transconductance of this arrangement 1 may be increased as compared to a standard MESFET because edge effect enhance the field strength in the active region 7 and because the current is being pinched off from both sides of the channel. As a result of the above, a substantially higher frequency of **operation can be expected from a permeable gate transistor** arrangement 1 of the present invention as compared to a MESFET of similar dimentions.

The gate portions 11 may have different configurations and different spacings from one another, as desired or required to obtain the desired performance from the arrangement 1. So, for instance, as shown in FIG. 4, the gate portions 11 may have substantially square cross sections and the intervening spaces 12 may also have identical square cross-sectional configurations. On the other hand, the gate portions shown in Fig. 5 and identified by the reference numeral 11' to distinguish them from the square gate portions 11 of Fig. 4, are triangular in cross section, with one side of this triangular cross section being parallel to the direction along which the source and drain formations 5 and 4 and the gate formation 6 extend, and with one corner pointing toward one of the source and drain formations 5 and 4, in the illustrated case toward the source formation 5.

While I have described above the principles of my invention in connection with specific apparatus, it is to be clearly understood that this description is made only by way of example and not as a limitation to the scope of my invention as set forth in the objects thereof and in the accompanying claims.

Claims:

1. A field effect transistor comprising a semiconductor body (2) having two major surfaces and including a substrate and an active region (7) of one conductivity type forming a channel at one of said major surfaces;

source and drain formations (5, 4) extending substantially parallel to a predetermined direction at said one major surface in juxtaposition with said active region (7) and spaced from one another transversely to said predetermined direction; and

a permeable gate formation (6) disposed at said one major surface between said source and drain formations (5, 4) in substantial parallelism with said predetermined direction and including

a plurality of gate portions (11) situated at said semiconductor body (2) and spaced from one another in said predetermined direction by predetermined distances to form intervening spaces (12), and

a plurality of connecting portions integral with and interconnecting respective adjacent ones of said gate portions (11) remotely from said body for supplying electric current to said gate portions for depleting respective individual depletion zones of said active region at least between said adjacent gate portions for

0225566

E.L.Griffin - 1                          Go/bk - Fl 1324 EP

26.11.86

controlling the flow of electric current in said channel between said source and drain formations (5,4).

2. The transistor as defined in Claim 1, wherein said active region (7) has portions situated underneath said gate portions (11), at least such active region portions having a relatively small thickness to be completely depleted at a relatively low initial value of electric field emanating from said gate portions (11) with attendant reduction in capacitance, while said predetermined distances between said gate portions are such as to obtain, upon achieving such complete depletion of said active region portions, relatively high electric current flow through conduction zones of said channel situated intermediate said individual depletion zones and underneath said intervening spaces, and gradually diminishing electric current flow as the electric field values increase beyond said initial value with attendant spread of said individual depletion zones (17) at the expense of the respective conduction zones to underneath said intervening spaces.

3. The transistor as defined in Claim 1, wherein said predetermined distances between said gate portions (11) are substantially equal to one another.

4. The transistor as defined in Claim 1, and further comprising respective bodies of solid dielectric material substantially filling said intervening spaces (12) bounded by the respective adjacent gate and connecting portions of said gate formation.

5. The transistor as defined in Claim 1, wherein each of said gate portions (11) has a substantially rectangular cross section in a plane parallel to said one major surface.

6. The transistor as defined in Claim 5, wherein two sides of said rectangular cross section are substantially parallel to said predetermined direction and are closest to said source and drain formations (4, 5), respectively.

7. The transistor as defined in Claim 1, wherein each of said gate portions (11′) has a substantially triangular cross section in a plane parallel to said one major surface.

8. The transistor as defined in Claim 7, wherein one side of said triangular cross section is substantially parallel to said predetermined direction and is closest to one of said source and drain formations (4, 5), while an opposite corner of said triangular cross section is closest to the other of said source and drain formations (4, 5).

9. The transistor as defined in Claim 1, wherein said connecting portions have delimiting surfaces which partially delimit said intervening spaces between said gate portions (11) and are substantially parallel to said one major surface.

Fig. 1

Fig. 2

Fig. 3

_Fig. 4_

_Fig. 5_